# EUROPEAN PATENT APPLICATION

(11) **EP 4 852 639 A1**
(43) Date of publication of application: **09.12.2026**
(21) Application number: 26182400.7
(22) Date of filing: 01.06.2026
(51) Int. Cl.: H05K 7/20

(54) **FAN MOUNTING TECHNOLOGY FOR AIR-COOLED EQUIPMENT**

(30) Priority: 05.06.2025 US 202563818476 P; 24.10.2025 US 202519368741
(71) Applicant: Cisco Technology, Inc., San Jose, CA 95134 (US)
(72) Inventor: LI, Daolin, Shanghai, 201620 (CN); LI, Xiaogang, Shanghai, 200231 (CN); HSUEH, Solomon C. Y., Shanghai, 200011 (CN); PILLAI, Harikrishnan, San Jose, 95129 (US); GOERGEN, Joel R., Soulsbyville, 95372 (US); ZHOU, Fan, Saratoga, 95070 (US)
(74) Representative: Mathys & Squire

(57) **Abstract**

Rack-mounted servers having fan modules or fan assemblies are provided. In one aspect, a rack-mounted server includes a chassis and a fan module installable in, and removable from, the chassis. The fan module or fan assembly is arranged so that the fan module or fan assembly is installable in the chassis from both a top position and a rear position, and so that the fan module or fan assembly is removable from the chassis from both the top position and the rear position.

## Description

### TECHNICAL FIELD

This disclosure relates to rack-mounted servers, and more particularly, to rack-mounted servers having fan modules for air cooling.

### BACKGROUND

Existing rack-mounted server designs allow for the installation and removal of fan modules from either the top or the rear side of the system. This poses a challenge when deploying these systems at different edge and retail locations at scale with various mounting and rack options, where in some cases the same system will have other equipment on the top (like in case of racks) and require fan access to be from the rear side. Further, in some retail locations, the equipment is on a wall-mounted rack where there is no rear access to the fans, requiring top-side fan access. This can limit the deployment options of rack-mounted servers. Accordingly, access or removal from only the top or only the rear of the system can present certain challenges.

### BRIEF DESCRIPTION OF THE DRAWINGS

So that the manner in which the above-recited features of the present disclosure can be understood in detail, a more particular description of the disclosure, briefly summarized above, may be had by reference to embodiments, some of which are illustrated in the appended drawings. It is to be noted, however, that the appended drawings illustrate typical embodiments and are therefore not to be considered limiting; other equally effective embodiments are contemplated.
FIG. 1 is a perspective view of a portion of a rack-mounted server, according to one or more aspects of the present disclosure.
FIG. 2 is a front perspective view of a fan module of the rack-mounted server of FIG. 1.
FIG. 3 is a rear perspective view of the fan module of FIG. 2.
FIG. 4 is a perspective view of a portion of the rack-mounted server of FIG. 1, with one of the fan modules being pulled out or removed from the chassis from the top.
FIG. 5 is a forward-looking-rear cross-sectional view of two of the fan modules of the rack-mounted server of FIG. 1.
FIG. 6 is a perspective view of a portion of the rack-mounted server of FIG. 1, with one of the fan modules being pulled out or removed from the chassis from the rear and with a removable top cover of the rack-mounted server remaining in place.
FIG. 7 is a rear-looking-forward cross-sectional view of one of the fan modules of the rack-mounted server of FIG. 1.
FIG. 8 is a perspective view of a portion of a rack-mounted server having a fan tray being removed from the chassis from a top position, according to one or more aspects of the present disclosure.
FIG. 9 is a cross-sectional view of side latches of the rack-mounted server of FIG. 8.
FIG. 10 is a perspective view of the rack-mounted server of FIG. 8, with the fan tray being removed from the chassis from the rear position.
FIG. 11 is a perspective view of the rack-mounted server of FIG. 8, with the fan tray locked in place within the chassis.

To facilitate understanding, identical reference numerals have been used, where possible, to designate identical elements that are common to the figures. It is contemplated that elements disclosed in one embodiment may be beneficially used in other embodiments without specific recitation.

### DESCRIPTION OF EXAMPLE EMBODIMENTS

### OVERVIEW

Aspects of the invention are set out in the independent claims and preferred features are set out in the dependent claims. Features of one aspect may be applied to each aspect alone or in combination with other features.

In one aspect, a rack-mounted server is provided. The rack-mounted server includes a chassis and a fan module installable in, and removable from, the chassis. The fan module is arranged so that the fan module is installable in the chassis from both a top position and a rear position, and so that the fan module is removable from the chassis from both the top position and the rear position.

In another aspect, a rack-mounted server is provided. The rack-mounted server includes a chassis and a fan assembly having a fan tray and a plurality of fan modules disposed in the fan tray. The fan tray is installable in, and removable from, the chassis. The fan tray is arranged so that the fan tray is installable in the chassis from both a top position and a rear position, and so that the fan tray is removable from the chassis from both the top position and the rear position.

In yet another aspect, a fan module is provided. The fan module includes a housing having a top wall, a bottom wall, a left side wall, and a right side wall. The fan module also includes a fan disposed in the housing. Further, the fan module includes a plurality of latches, including a top latch arranged at the top wall, a bottom latch arranged at the bottom wall, a left side latch arranged at the left side wall, and a right side latch arranged at the right side wall.

In one or more aspects of the fan module, the top, bottom, left side, and right side latches each have a latch handle and a latch arm movable between a deployed position and a retracted position. In one or more aspects, the fan module is suitable for use in air-cooled equipment more generally, including but not limited to rack-mounted servers, network switches, routers, storage arrays, and other rack-mounted electronic equipment requiring forced-air cooling.

In a further aspect, a fan assembly is provided. The fan assembly includes a fan tray, a plurality of fans disposed in the fan tray, and a plurality of latches. The plurality of latches include a first left tray latch and a first right tray latch arranged at a left side and a right side of the fan tray, respectively. Also, the plurality of latches include a second left tray latch and a second right tray latch arranged at the left side and the right side of the fan tray, respectively.

In one or more aspects of the fan assembly, the fan tray is configured to carry a plurality of fan modules and to be installable in, and removable from, a chassis from both a top position and a rear position. In one or more aspects, the fan assembly is suitable for use in air-cooled equipment more generally, including but not limited to rack-mounted servers, network switches, routers, storage arrays, and other rack-mounted electronic equipment requiring forced-air cooling.

In another aspect, a method of removing a fan module from a rack-mounted server is provided. The method includes providing a fan module that includes a housing having a top wall, a bottom wall, a left side wall, and a right side wall. The fan module also includes a fan disposed in the housing. Further, the fan module includes a plurality of latches, including a top latch arranged at the top wall, a bottom latch arranged at the bottom wall, a left side latch arranged at the left side wall, and a right side latch arranged at the right side wall. The method also includes removing the fan module from a top position by releasing the right and left side latches or from a rear position by releasing the top latch and the bottom latch.

In one or more aspects, in removing the fan module from the top position, a removable top cover of the rack-mounted server is removed to allow for the fan module to be removed from the top position.

In yet another aspect, a method of removing a fan tray from a rack-mounted server is provided. The method includes providing a fan assembly that includes the fan tray, a plurality of fans disposed in the fan tray, and a plurality of latches. The latches include a first left tray latch and a first right tray latch arranged at a left side and a right side of the fan tray, respectively. Also, the latches include a second left tray latch and a second right tray latch arranged at the left side and the right side of the fan tray, respectively. The method also includes removing the fan tray from a top position by releasing the first left tray latch and the first right tray latch or a rear position by releasing the second left tray latch and the second right tray latch.

In one or more aspects, in removing the fan tray from the top position, a removable top cover of the rack-mounted server is removed to allow for the fan tray to be removed from the top position.

### EXAMPLE EMBODIMENTS

Various rack-mounted servers are disclosed herein that allow for fan modules to be installed and removed from both the top and the rear sides of the chassis, which offers multiple deployment options and increased flexibility.

In at least one example, a fan module for a rack-mounted server is disclosed. The fan module locks with a chassis by dual-engaging top and bottom latches and left and right-side latches. So, even when a removable top cover of a chassis of the rack-mounted server is removed, the fan module can remain firmly locked within the chassis and can work normally. The fan module can be pulled out of chassis from the top by releasing its left- and right-side latches by pinching them after the removable top cover is removed. The fan module can be translated vertically out of the chassis. The fan module can also be pulled out of chassis from the rear side with the removable top cover still in place. The top and bottom latches can be unlocked by pressing them, and the left- and right-side latches are designed so that the fan module can be slid out without any interference. The fan module can be translated horizontally out of the chassis. Further, the fan module and a fan controller board are arranged to mate or become unmated in both install/removal directions. Moreover, low acoustics can be maintained.

In at least one example, features that allow for fan tray installation and removal are provided. The fan tray can carry a plurality of fan modules. Unique dual-engaging tray latches of the fan tray provide mating/un-mating ability from the rear and the top of the chassis. That is, the fan tray is installable and removable from the chassis both vertically and horizontally.

In at least one example, fault indicators (e.g., LEDs) that are visible for both top and rear access modes can be employed. In at least one example, the fault indicators can indicate whether a given fan module has been satisfactorily installed within the chassis of a rack-mounted server. For instance, in the event an electrical connector of the fan module does not properly connect to an electrical connector of the chassis, a fault indicator can indicate that a fault is present. The fault indicator can be coupled with a current sensor or the like to sense when a fault is present.

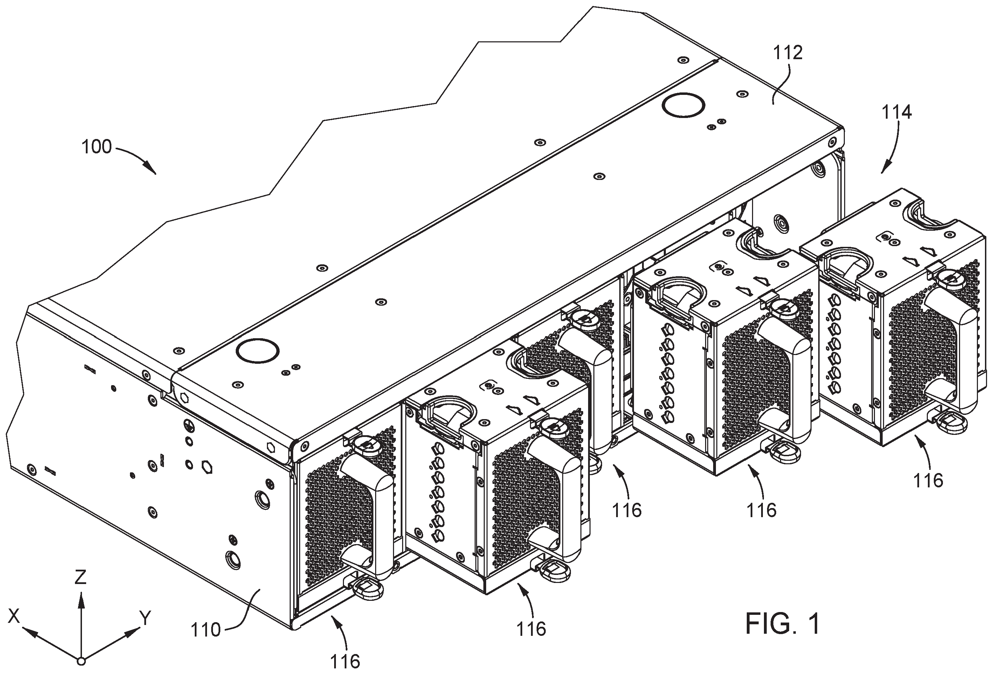

Turning now to the drawings, FIG. 1 shows a perspective view of a portion of a rack-mounted server 100 according to one or more aspects of the present disclosure. For reference, the rack-mounted server 100 defines an X-direction, a Y-direction, and a Z-direction, which are mutually perpendicular to one another. In one or more examples, the X-direction is a longitudinal direction, the Y-direction is a lateral direction, and the Z-direction is a vertical direction.

The rack-mounted server 100 includes a chassis 110 having a removable top cover 112. The chassis 110 can enclose various components, such as processing cards, switches, one or more processors, one or more memory devices, etc. The rack-mounted server 100 also includes a fan assembly 114 having a plurality of fan modules 116. The fan assembly 114, or fans thereof, are arranged to move air through the chassis 110 to cool the components enclosed therein. In this example, the fan assembly 114 is arranged at a rear side of the chassis 110. However, in other examples, the fan assembly 114 can be arranged at a different side of the chassis 110, such as at the front or side of the chassis 110.

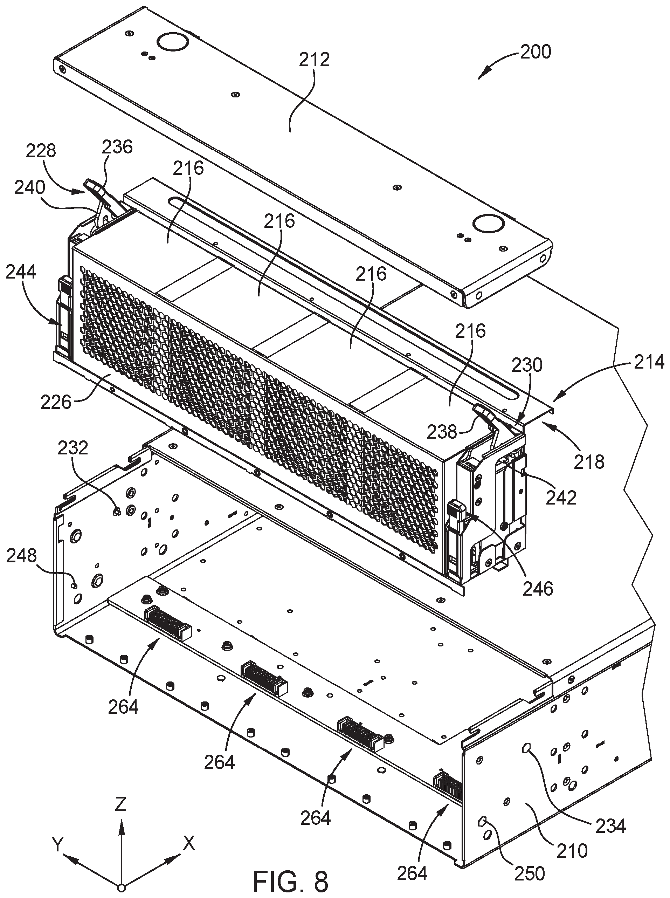

In one or more examples, the fan modules 116 are removable individually from the rack-mounted server 100, e.g., as shown in FIG. 1. In one or more other examples, the fan modules 116 are arranged in a fan tray, and the fan tray is removable from the rack-mounted server 100 (see FIGS. 8, 9, 10, and 11).

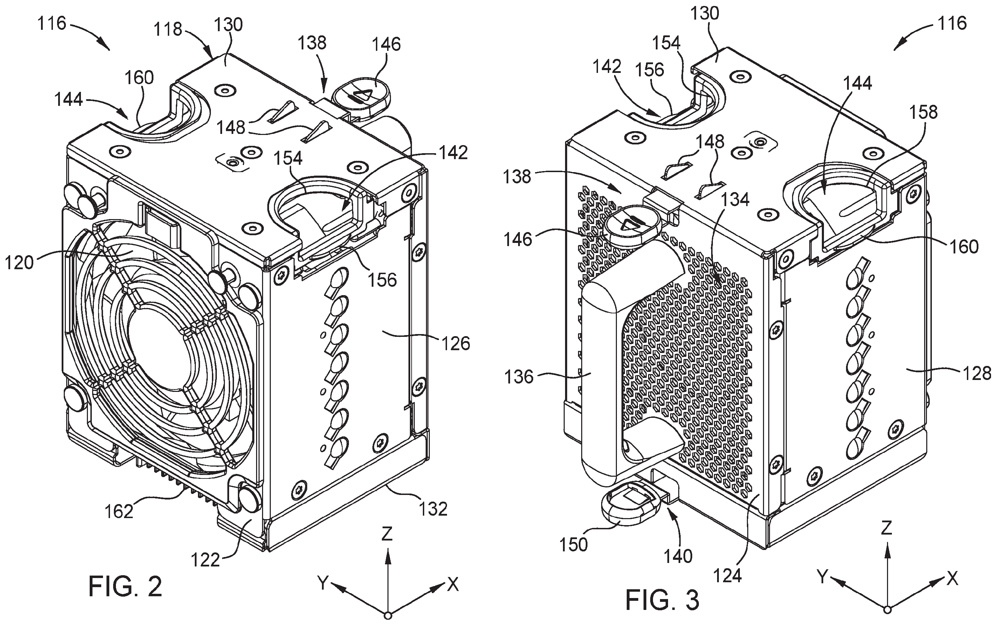

FIGS. 2 and 3 show perspective views of one of the fan modules 116 of the rack-mounted server 100. FIG. 2 shows a front perspective view of the fan module 116 and FIG. 3 shows a rear perspective view of the fan module 116. The fan module 116 has a housing 118 in which a fan 120 is disposed. In this example, air enters the front side of the fan module 116 and exits through the rear side, e.g., through a perforated wall at the rear side. The housing 118 has a front wall 122, a rear wall 124, a first side wall 126, a second side wall 128, a top wall 130, and a bottom wall 132. The rear wall 124 defines perforations 134 that allow air to exit the rear side of the fan module 116. A module handle 136 extends from the rear wall 124. A user may grasp the module handle 136 to install or remove the fan module 116 from the chassis 110 (FIG. 1).

The fan module has a plurality of latches, including a top latch 138, a bottom latch 140, a left latch 142, and a right latch 144.

As described throughout this disclosure, the left and right latches can be considered side latches. The left latch is "left" while the right latch is "right" from the rear perspective.

As shown in FIGS. 2 and 3, the top latch 138 is arranged at the top wall 130. The top latch 138 has a latch handle 146 and latch arms 148. The latch arms 148 are movable between a deployed position (shown in both FIGS. 2 and 3) and a retracted position. Specifically, the latch handle 146 can be pressed downward, e.g., along the Z-direction, to retract the latch arms 148 within the top wall 130.

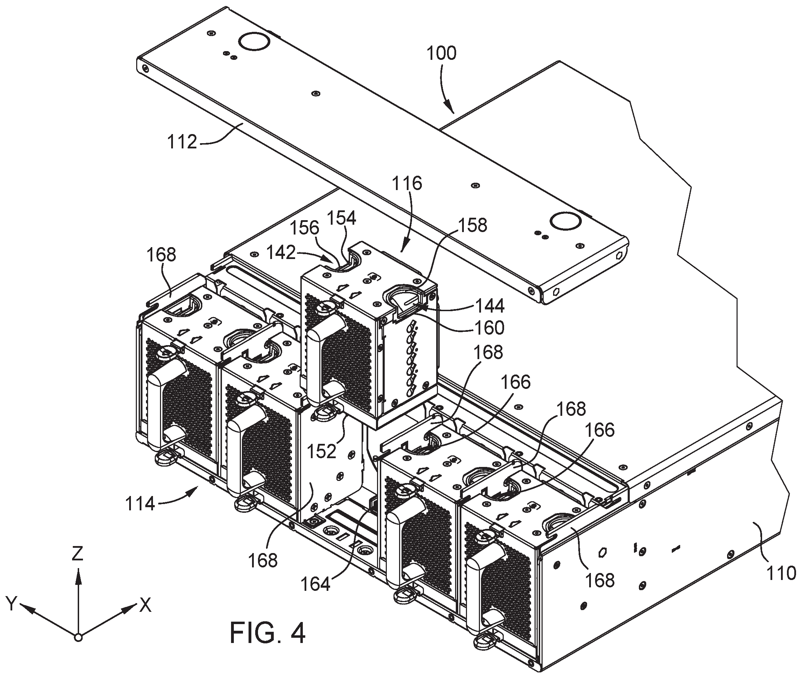

The bottom latch 140 is arranged at the bottom wall 132. The bottom latch 140 has a latch handle 150 and latch arms 152 (not depicted in FIGS. 2 and 3; but, the latch arms 152 of the bottom latch 140 are arranged in a similar manner as the latch arms 148 of the top latch 138, and one of the latch arms 152 of one of the fan modules 116 is shown in FIG. 4). The latch arms 152 of the bottom latch 140 are movable between a deployed position and a retracted position. Specifically, the latch handle 150 of the bottom latch 140 can be pressed upward, e.g., along the Z-direction, to retract the latch arms 152 within the bottom wall 132. When the latch handles 146, 150 of the top and bottom latches 138, 140 are pressed at the same time to retract their respective latch arms 148, 152, the fan module 116 can be "released" and removed from a rear side of the chassis 110.

The left latch 142 is arranged at a left side of the top wall 130. The left latch 142 has a latch handle 154 and a latch arm 156. The latch arm 156 is movable between a deployed position (shown in both FIGS. 2 and 3) and a retracted position. Specifically, the latch handle 154 can be pressed or pinched to retract the latch arm 156 within the first side wall 126 (the left side wall in this example).

The right latch 144 is arranged at a right side of the top wall 130. The right latch 144 has a latch handle 158 and a latch arm 160. The latch arm 160 of the right latch 144 is movable between a deployed position (shown in both FIGS. 2 and 3) and a retracted position. Specifically, the latch handle 158 of the right latch 144 can be pressed or pinched to retract the latch arm 160 within the second side wall 128 (the right side wall in this example). When the latch handles 154, 158 of the left and right latches 142, 144 are pressed or pinched at the same time to retract their respective latch arms 156, 160, the fan module 116 can be "released" and removed from a top side of the chassis 110.

In one or more examples, with reference now to FIGS. 1, 4, and 6, the fan modules 116 of the rack-mounted server 100 are each installable in, and removable from, the chassis 110 from both a top position and a rear position. That is, each one of the fan modules 116 is arranged to be installable in the chassis 110 from both a top position and a rear position, and to be removable from the chassis 110 from both the top position and the rear position. Each one of the fan modules 116 locks with the chassis 110 by their respective dual-engaging top and bottom latches 138, 140 and left and right-side latches 142, 144. So, even when the removable top cover 112 is removed, the fan modules 116 can remain firmly locked with the chassis 110 and work normally.

In at least one example, the fan modules 116 can each be removed or installed from the top, or rather, vertically. For instance, in FIG. 4, one of the fan modules 116 is depicted being pulled out or removed from the chassis 110 from the top. First, the removable top cover 112 can be removed. Second, the left and right latches 142, 144 of the fan module 116 can be released, e.g., by pinching them. That is, the latch arm 156 of the left side latch 142 moves to the retracted position in which the latch arm 156 of the left side latch 142 is retracted within the left side wall 126 in response to the latch handle 154 of the left side latch 142 being pressed, which releases the left side latch 142. Moreover, the latch arm 160 of the right side latch 144 moves to the retracted position in which the latch arm 160 of the right side latch 144 is retracted within the right side wall 128 in response to the latch handle 158 of the right side latch 144 being pressed, which releases the right side latch 144.

Particularly, when the latch handles 154, 158 of the left and right latches 142, 144 are pressed or pinched at the same time, their respective latch arms 156, 160 retract and release from respective side latch recesses 166 defined by divider plates 168 arranged on both sides of the fan module 116 (when the fan module 116 is positioned in place within the chassis 110). Accordingly, with the left and right latches 142, 144 released from the divider plates 168, the fan module 116 can be removed from the top side of the chassis 110, or rather, lifted vertically out of the chassis 110, e.g., along the Z-direction.

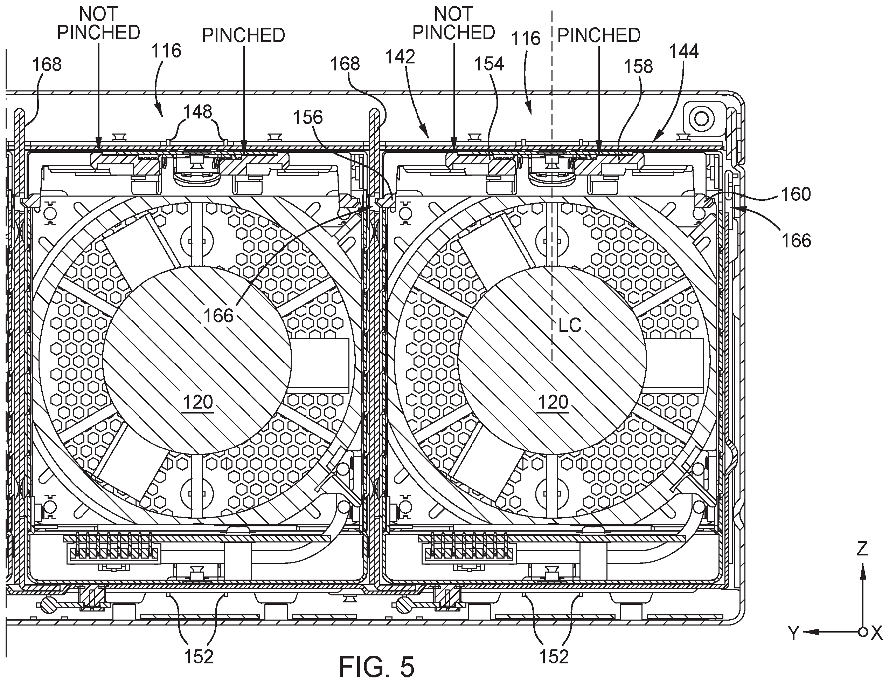

FIG. 5 is a forward-looking-rear cross-sectional view of two of the fan modules 116 of the rack-mounted server 100. In at least one example, as shown in FIG. 5, the latch handles 154, 158 of the left and right latches 142, 144 are both spring-loaded and biased so that their respective latch arms 156, 160 are urged toward their respective deployed positions. In FIG. 5, the latch handle 154 is not pressed or pinched, and consequently, the latch arm 156 is deployed and is positioned, at least in part, in the side latch recess 166. When the latch arm 156 is positioned within the side latch recess 166, the fan module 116 is prevented from being removed from the chassis 110 from the top position, or rather, vertically. In contrast, in FIG. 5, the latch handle 158 is pressed or pinched in the Y-direction toward a lateral centerline LC of the fan module 116, and consequently, the latch arm 160 is retracted within the side wall of the fan module 116 and is not positioned, at least in part, in the side latch recess 166. This allows the fan module 116 to be removed from the chassis 110 from the top position (however, in this example, the latch handle 154 would also need to pressed or pinched to allow the fan module 116 to be removed vertically from the chassis 110). In FIG. 5, because the latch handle 158 is pressed or pinched in the Y-direction toward the lateral centerline LC of the fan module 116, and the latch handle 154 is not, the latch handle 158 is positioned closer to the lateral centerline LC than is the latch handle 154 along the Y-direction.

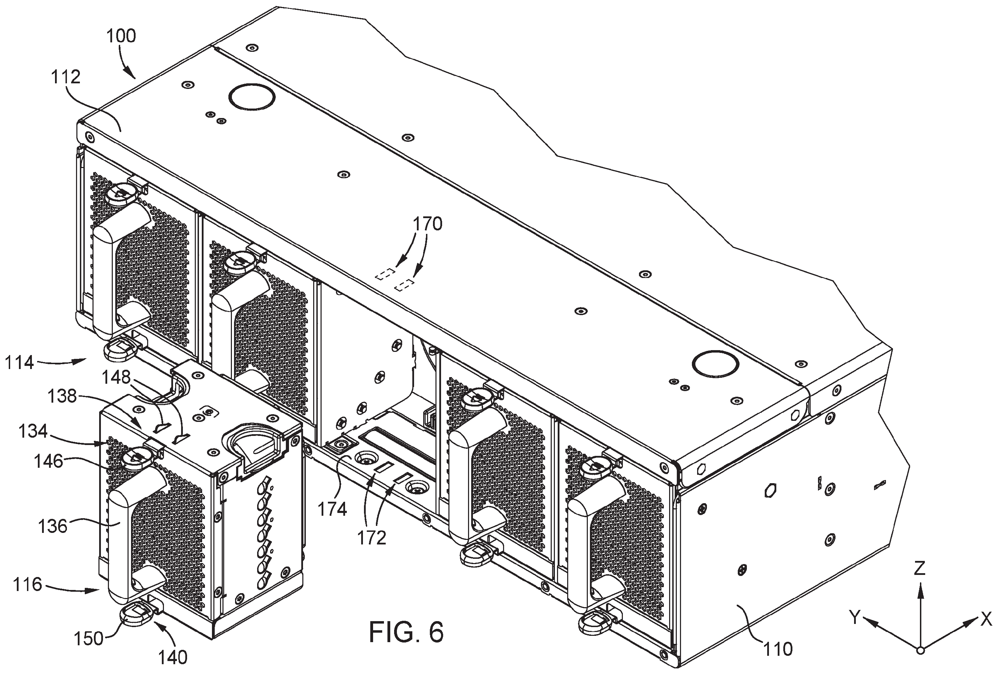

In addition, the fan modules 116 can also be removed or installed from the rear, or rather, horizontally. For instance, in FIG. 6, the fan module 116 is depicted being pulled out or removed from the chassis 110 from the rear, with the removable top cover 112 remaining in place. Particularly, when the latch handles 146, 150 of the top and bottom latches 138, 140 are pressed at the same time, their respective latch arms 148, 152 (latch arms 152 are depicted in FIG. 5) retract and release from top and bottom latch recesses 170, 172 defined by the removable top cover 112 and a bottom wall 174 of the chassis 110, respectively. That is, the latch arms 148 of the top latch 138 move to the retracted position in which the latch arms 148 are retracted within the top wall 130 in response to the latch handle 146 being pressed, which releases the top latch 138. Moreover, the latch arms 152 of the bottom latch 140 move to the retracted position in which the latch arms 152 of the bottom latch 140 are retracted within the bottom wall 132 in response to the latch handle 150 of the bottom latch 140 being pressed, which releases the bottom latch 140.

Accordingly, with the top and bottom latches 138, 140 released from the chassis 110, the fan module 116 can be pulled out from the rear side of the chassis 110 e.g., along the X-direction, or rather, removed horizontally out of the chassis 110. The top and bottom latches 138, 140 are arranged so that the fan module 116 can be slid out from the rear side without any interference. Accordingly, the fan module 116 (the middle fan module in this example) of FIGS. 4 and 6 is installable and removable from both the top position and the rear position. The other fan modules 116 are likewise each individually installable and removable from both the top and rear positions.

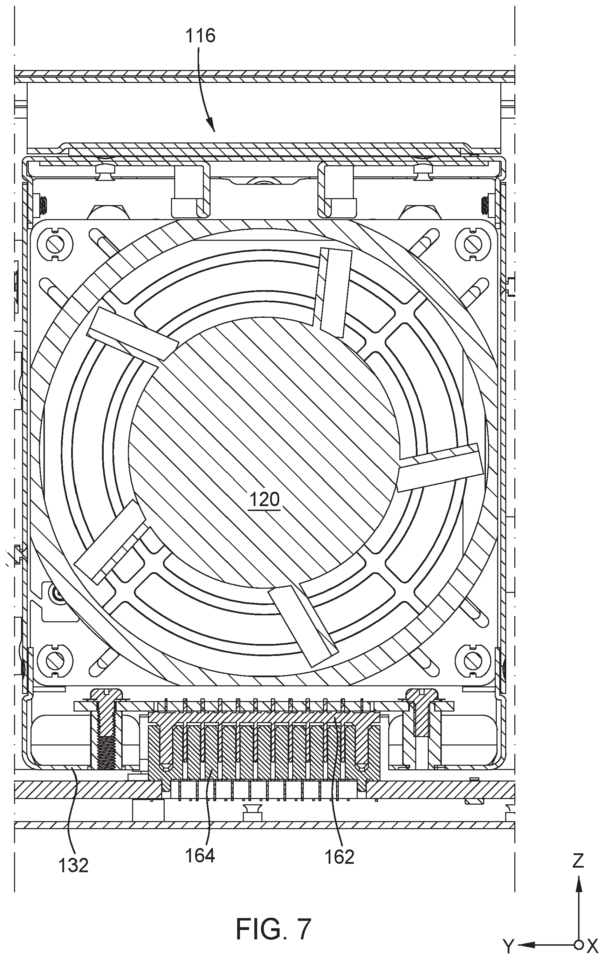

As shown in the rear-looking-forward cross-sectional view of FIG. 7, the fan module 116 also has a fan module connector 162 arranged at the bottom wall 132. The fan module connector 162 can electrically connect the fan module 116 with an electrical connector 164 arranged within the chassis 110 (see also FIG. 4). The fan module connector 162 can become electrically coupled, or electrically decoupled, with the electrical connector 164 in both install top and rear positions as well as both removal top and rear positions. In this example, the electrical connector 164 has a base plate and upward extending electrically-conductive fingers and the fan module connector 162 has a base plate and downward extending electrically-conductive fingers that are interspersed (or in this example interdigitated) between the upward extending electrically-conductive fingers of the electrical connector 164. The fingers of the fan module connector 162 can slide between the fingers of the electrical connector 164 along the X-direction when the fan module 116 is installed from the rear position (or slid away from each other along the X-direction during removal of the fan module 116 from the chassis 110 from the rear position). The fingers of the fan module connector 162 can drop down in between the fingers of the electrical connector 164 along the Z-direction when the fan module 116 is installed from the top position (or moved upward away from the fingers of the electrical connector 164 during removal of the fan module 116 from the chassis 110 from the top position). Thus, the fingers of the fan module connector 162 and the electrical connector 164 can form an electrical interface between the fan module 116 and the electrical system of the chassis 110.

In one or more further examples, a rack-mounted server includes a chassis, a removable top cover, and a fan assembly having a plurality of fan modules arranged in a fan tray. The fan tray is installable in, and removable from, the chassis. Particularly, the fan tray is arranged so that the fan tray is installable in the chassis from both a top position and a rear position, and so that the fan tray is removable from the chassis from both the top position and the rear position. An example rack-mounted having such features is disclosed below.

FIG. 8 shows a perspective view of a portion of a rack-mounted server 200 according to one or more aspects of the present disclosure. For reference, the rack-mounted server 200 defines an X-direction, a Y-direction, and a Z-direction, which are mutually perpendicular to one another. In one or more examples, the X-direction is a longitudinal direction, the Y-direction is a lateral direction, and the Z-direction is a vertical direction.

The rack-mounted server 200 includes a chassis 210 having a removable top cover 212. The chassis 210 can enclose various components, such as processing cards, switches, one or more processors, one or more memory devices, etc. The rack-mounted server 200 also includes a fan assembly 214 having a plurality of fan modules 216. The fan modules 216, or fans thereof, are operable to move air through the chassis 210 to cool the components enclosed therein. In this example, the fan assembly 214 is arranged at a rear side of the chassis 210. However, in other examples, the fan assembly 214 can be arranged at a different side of the chassis 210, such as at the front or side of the chassis 210. Each fan module 216 has a fan module connector arranged at its bottom wall. The fan module connectors of the fan modules 216 can electrically connect with respective electrical connectors 264 arranged within the chassis 210.

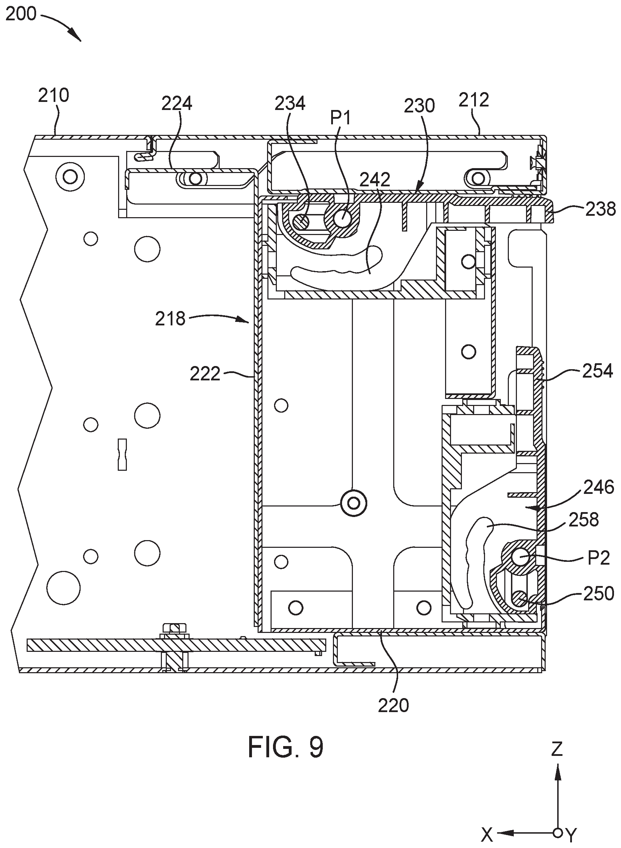

With reference now to FIGS. 8 and 9, the fan assembly 214 includes a fan tray 218 for holding or carrying the fan modules 216. The fan tray 218 has a bottom tray wall 220, a forward tray wall 222, a forward flange 224, and a perforated screen 226. The forward tray wall 222 defines openings to allow air to flow therethrough to the fan modules 216. The perforated screen 226 includes perforations aligned in flow communication with the fan modules 216 to allow air to exit the rack-mounted server 200.

As shown in FIG. 8, the fan tray 218 can be removed from the chassis 210 from the top position. First, the removable top cover 212 can be removed. Then, a first left tray latch 228 and a first right tray latch 230 of the fan tray 218 can be released from a first left tray pin 232 and a first right tray pin 234, respectively. A latch handle 236 of the first left tray latch 228 and a latch handle 238 of the first right tray latch 230 can both be rotated upward to release their respective latch arms 240, 242 from their respective first left and right tray pins 232, 234. With the first left tray latch 228 and the first right tray latch 230 released, the fan tray 218 can be lifted vertically out of the chassis 210, e.g., upward along the Z-direction. To install the fan tray 218, the removable top cover 212 can be removed, and then the fan tray 218 can be lowered into the chassis 210 from the top position, e.g., along the Z-direction. The latch arms 240, 242 of the first left tray latch 228 and the first right tray latch 230 can lockingly engage the first left tray pin 232 and the first right tray pin 234, respectively. The removable top cover 212 can then be positioned in place.

Accordingly, the first left tray latch 228 and the first right tray latch 230 are movable so as to lockingly engage, or release from, the first left tray pin 232 and the first right tray pin 234, respectively, allowing the fan tray 218 to be installed, or removed, from the chassis 210 from the top position.

In at least one example, the first left tray latch 228 and the first right tray latch 230 can be pivoted or rotated about respective pitch axes so as to lockingly engage, or release from, the first left tray pin 232 and the first right tray pin 234, respectively. For instance, with reference to FIG. 9, the first right tray latch 230 is pivotable about a pitch axis P1 at a revolute joint provided by a pin. The pitch axis P1 extends along the Y-direction in this example. When the first right tray latch 230 is in a horizontal orientation, the first right tray latch 230 is lockingly engaged with the first right tray pin 234 as illustrated in FIG. 9. When the first right tray latch 230 is rotated to a non-horizontal orientation, e.g., as shown in FIG. 8, the first right tray latch 230 is released from the first right tray pin 234, which allows the fan tray 218 to be moved vertically along the Z-direction.

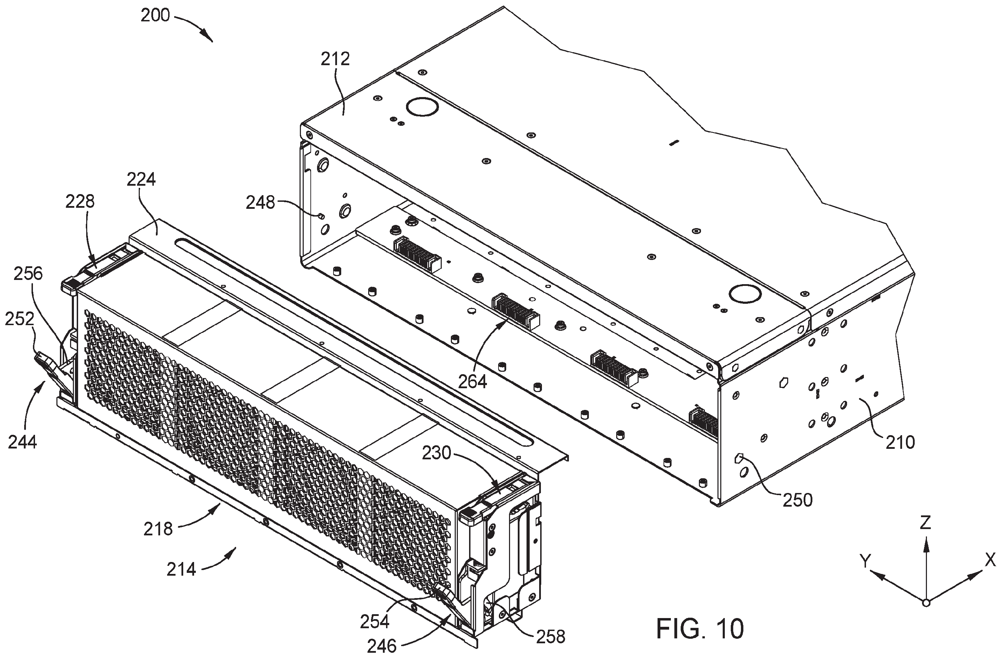

As depicted in FIG. 10, the fan tray 218 can be removed from the chassis 210 from the rear position. With the removable top cover 212 remaining in place, a second left tray latch 244 and a second right tray latch 246 of the fan tray 218 can be released from a second left tray pin 248 and a second right tray pin 250, respectively. A latch handle 252 of the second left tray latch 244 and a latch handle 254 of the second right tray latch 246 can both be rotated downward to release their respective latch arms 256, 258 from their respective second left and right tray pins 248, 250. With the second left and right tray latches 244, 246 released, the fan tray 218 can be pulled from the rear position out of the chassis 210, e.g., along the X-direction. To install the fan tray 218, the removable top cover 212 can be arranged in place, or kept in place, and the fan tray 218 can be pushed into the chassis 210 from the rear position, e.g., along the X-direction. The latch arms 256, 258 of the second left tray latch 244 and the second right tray latch 246 can lockingly engage the second left tray pin 248 and the second right tray pin 250, respectively.

Accordingly, the second left tray latch 244 and the second right tray latch 246 are movable so as to lockingly engage, or release from, the second left tray pin 248 and the second right tray pin 250, respectively, allowing the fan tray 218 to be installed, or removed, from the chassis 210 from the rear position.

In at least one example, the second left tray latch 244 and the second right tray latch 246 can be pivoted or rotated about respective pitch axes so as to lockingly engage, or release from, the second left tray pin 248 and the second right tray pin 250, respectively. For instance, with reference to FIG. 9, the second right tray latch 246 is pivotable about a pitch axis P2 at a revolute joint provided by a pin. The pitch axis P2 extends along the Y-direction in this example. When the second right tray latch 246 is in a vertical orientation, the second right tray latch 246 is lockingly engaged with the second right tray pin 250 as illustrated in FIG. 9. When the second right tray latch 246 is rotated to a non-vertical orientation, e.g., as shown in FIG. 10, the second right tray latch 246 is released from the second right tray pin 250, which allows the fan tray 218 to be moved horizontally, e.g., in the X-direction.

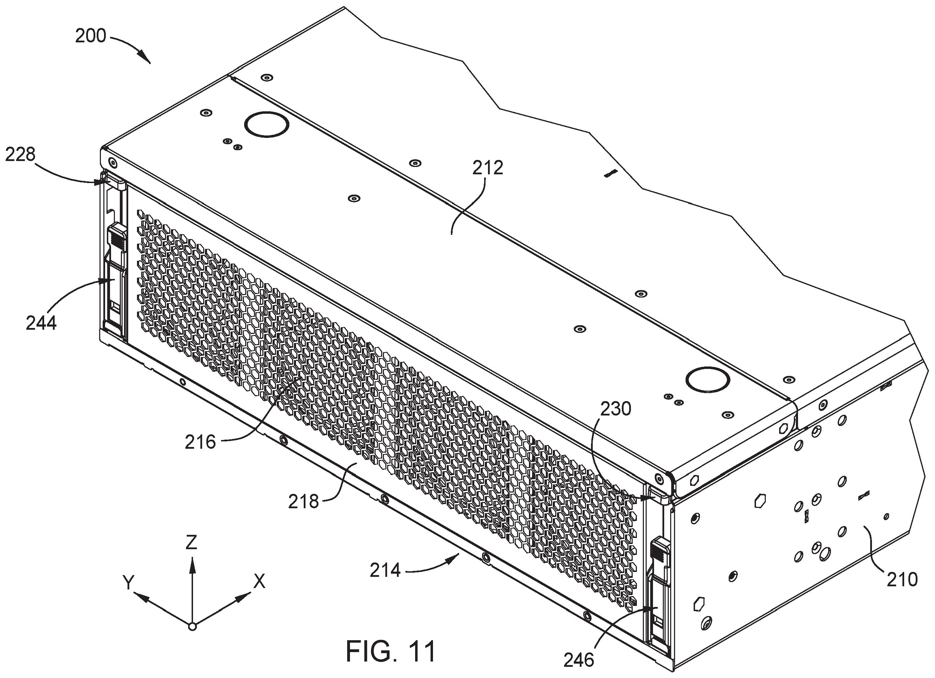

In FIG. 11, the fan tray 218 is shown locked in place within the chassis 210. In at least one example, the first left tray latch 228 and the first right tray latch 230 are horizontally-oriented when the fan tray 218 is installed in the chassis 210, and the second left tray latch 244 and the second right tray latch 246 are vertically-oriented when the fan tray 218 is installed in the chassis 210.

While the fan tray 218 of FIGS. 8, 9, 10, and 11 holds four (4) fans or fan modules, in other examples, the fan tray 218 can hold more or less than four (4) fans or fan modules.

In the current disclosure, reference is made to various embodiments. However, the scope of the present disclosure is not limited to specific described embodiments. Instead, any combination of the described features and elements, whether related to different embodiments or not, is contemplated to implement and practice contemplated embodiments. Additionally, when elements of the embodiments are described in the form of "at least one of A and B," or "at least one of A or B," it will be understood that embodiments including element A exclusively, including element B exclusively, and including element A and B are each contemplated. Furthermore, although some embodiments disclosed herein may achieve advantages over other possible solutions or over the prior art, whether or not a particular advantage is achieved by a given embodiment is not limiting of the scope of the present disclosure. Thus, the aspects, features, embodiments, and advantages disclosed herein are merely illustrative and are not considered elements or limitations of the appended claims except where explicitly recited in a claim(s).

The systems described herein are also exemplified in the following numbered clauses:
1. A rack-mounted server, comprising:
   a chassis; and
   a fan module installable in, and removable from, the chassis, wherein the fan module is arranged so that the fan module is installable in the chassis from both a top position and a rear position, and so that the fan module is removable from the chassis from both the top position and the rear position.
2. The rack-mounted server of clause 1, wherein the fan module comprises:
   a housing having a top wall, a bottom wall, a left side wall, and a right side wall;
   a fan disposed in the housing; and
   a plurality of latches, including a top latch arranged at the top wall, a bottom latch arranged at the bottom wall, a left side latch arranged at the left side wall, and a right side latch arranged at the right side wall.
3. The rack-mounted server of clause 2, wherein:
   the top latch has a latch handle and a latch arm movable between a deployed position and a retracted position, and wherein the latch arm moves to the retracted position in which the latch arm is retracted within the top wall in response to the latch handle being pressed, and
   the bottom latch has a latch handle and a latch arm movable between a deployed position and a retracted position, and wherein the latch arm of the bottom latch moves to the retracted position in which the latch arm of the bottom latch is retracted within the bottom wall in response to the latch handle of the bottom latch being pressed.
4. The rack-mounted server of clause 3, wherein, when the latch handles of the top and bottom latches are pressed at a same time, their respective latch arms retract and release from top and bottom latch recesses defined by a removable top cover of the rack-mounted server and a bottom wall of the chassis, respectively, allowing the fan module to be installed, or removed, from the chassis from the rear position.
5. The rack-mounted server of clause 2, wherein:
   the left side latch has a latch handle and a latch arm movable between a deployed position and a retracted position, and wherein the latch arm of the left side latch moves to the retracted position in which the latch arm of the left side latch is retracted within the left side wall in response to the latch handle of the left side latch being pressed,
   the right side latch has a latch handle and a latch arm movable between a deployed position and a retracted position, and wherein the latch arm of the right side latch moves to the retracted position in which the latch arm of the right side latch is retracted within the right side wall in response to the latch handle of the right side latch being pressed.
6. The rack-mounted server of clause 5, wherein, when the latch handles of the left and right side latches are pressed toward each other at a same time, their respective latch arms retract and release from respective side latch recesses, allowing the fan module to be installed, or removed, from the chassis from the top position.
7. The rack-mounted server of clause 6, wherein the side latch recesses are defined by divider plates arranged on both sides of the fan module.
8. The rack-mounted server of clause 3, further comprising:
   a removable top cover removably mounted to the chassis, and wherein when the removable top cover is mounted to the chassis and the fan module is installed in the chassis, the fan module is positioned beneath the removable top cover.
9. The rack-mounted server of clause 1, wherein the fan module has a fan module connector electrically coupled with an electrical connector arranged within the chassis.
10. A fan module for a rack-mounted server, the fan module comprising:
   a housing having a top wall, a bottom wall, a left side wall, and a right side wall;
   a fan disposed in the housing; and
   a plurality of latches, including a top latch arranged at the top wall, a bottom latch arranged at the bottom wall, a left side latch arranged at the left side wall, and a right side latch arranged at the right side wall.
11. The fan module of clause 10, wherein:
   the top latch has a latch handle and a latch arm movable between a deployed position and a retracted position, and wherein the latch arm moves to the retracted position in which the latch arm is retracted within the top wall in response to the latch handle being pressed, and
   the bottom latch has a latch handle and a latch arm movable between a deployed position and a retracted position, and wherein the latch arm of the bottom latch moves to the retracted position in which the latch arm of the bottom latch is retracted within the bottom wall in response to the latch handle of the bottom latch being pressed.
12. The fan module of clause 11, wherein, when the latch handles of the top and bottom latches are pressed at a same time, their respective latch arms retract and release from top and bottom latch recesses defined by a removable top cover of the rack-mounted server and a bottom wall of a chassis of the rack-mounted server, respectively, allowing the fan module to be installed, or removed, from the chassis from a rear position.
13. The fan module of clause 10, wherein:
   the left side latch has a latch handle and a latch arm movable between a deployed position and a retracted position, and wherein the latch arm of the left side latch moves to the retracted position in which the latch arm of the left side latch is retracted within the left side wall in response to the latch handle of the left side latch being pressed,
   the right side latch has a latch handle and a latch arm movable between a deployed position and a retracted position, and wherein the latch arm of the right side latch moves to the retracted position in which the latch arm of the right side latch is retracted within the right side wall in response to the latch handle of the right side latch being pressed.
14. The fan module of clause 13, wherein, when the latch handles of the left and right side latches are pressed toward each other at a same time, their respective latch arms retract and release from respective side latch recesses, allowing the fan module to be installed, or removed, from a chassis of the rack-mounted server from a top position.
15. The fan module of clause 10, wherein the top and bottom latches have latch handles that are pressable toward one another and the left side and right side latches have latch handles that are pressable toward one another.
16. A rack-mounted server, comprising:
   a chassis; and
   a fan assembly having a fan tray and a plurality of fan modules disposed in the fan tray, and wherein the fan tray is installable in, and removable from, the chassis, wherein the fan tray is arranged so that the fan tray is installable in the chassis from both a top position and a rear position, and so that the fan tray is removable from the chassis from both the top position and the rear position.
17. The rack-mounted server of clause 16, wherein the fan tray comprises a plurality of latches, comprising:
   a first left tray latch and a first right tray latch arranged at a left side and a right side of the fan tray, respectively; and
   a second left tray latch and a second right tray latch arranged at the left side and the right side of the fan tray, respectively.
18. The rack-mounted server of clause 17, wherein the chassis has a first left tray pin and a first right tray pin, and wherein the first left tray latch and the first right tray latch are movable so as to lockingly engage, or release from, the first left tray pin and the first right tray pin, respectively, allowing the fan tray to be installed, or removed, from the chassis from the top position.
19. The rack-mounted server of clause 17, wherein the chassis has a second left tray pin and a second right tray pin, and wherein the second left tray latch and the second right tray latch are movable so as to lockingly engage, or release from, the second left tray pin and the second right tray pin, respectively, allowing the fan tray to be installed, or removed, from the chassis from the rear position.
20. The rack-mounted server of clause 17, wherein the first left tray latch and the first right tray latch are horizontally-oriented when the fan tray is installed in the chassis, and the second left tray latch and the second right tray latch are vertically-oriented when the fan tray is installed in the chassis.

In view of the foregoing, the scope of the present disclosure is determined by the claims that follow.

## Claims

1. A rack-mounted server, comprising:
a chassis; and
a fan module or a fan assembly having a fan tray and a plurality of fan modules disposed in the fan tray, the fan module or fan assembly installable in, and removable from, the chassis, wherein the fan module or fan assembly is arranged so that the fan module or fan assembly is installable in the chassis from both a top position and a rear position, and so that the fan module or fan assembly is removable from the chassis from both the top position and the rear position.

2. The rack-mounted server of claim 1, wherein the or each fan module comprises:
a housing having a top wall, a bottom wall, a left side wall, and a right side wall;
a fan disposed in the housing; and
a plurality of latches, including a top latch arranged at the top wall, a bottom latch arranged at the bottom wall, a left side latch arranged at the left side wall, and a right side latch arranged at the right side wall.

3. The rack-mounted server of claim 2, wherein:
the top latch has a latch handle and a latch arm movable between a deployed position and a retracted position, and wherein the latch arm moves to the retracted position in which the latch arm is retracted within the top wall in response to the latch handle being pressed, and
the bottom latch has a latch handle and a latch arm movable between a deployed position and a retracted position, and wherein the latch arm of the bottom latch moves to the retracted position in which the latch arm of the bottom latch is retracted within the bottom wall in response to the latch handle of the bottom latch being pressed.

4. The rack-mounted server of claim 3, wherein, when the latch handles of the top and bottom latches are pressed at a same time, their respective latch arms retract and release from top and bottom latch recesses defined by a removable top cover of the rack-mounted server and a bottom wall of the chassis, respectively, allowing the fan module to be installed, or removed, from the chassis from the rear position.

5. The rack-mounted server of any of claims 2 to 4, wherein:
the left side latch has a latch handle and a latch arm movable between a deployed position and a retracted position, and wherein the latch arm of the left side latch moves to the retracted position in which the latch arm of the left side latch is retracted within the left side wall in response to the latch handle of the left side latch being pressed,
the right side latch has a latch handle and a latch arm movable between a deployed position and a retracted position, and wherein the latch arm of the right side latch moves to the retracted position in which the latch arm of the right side latch is retracted within the right side wall in response to the latch handle of the right side latch being pressed.

6. The rack-mounted server of claim 5, wherein, when the latch handles of the left and right side latches are pressed toward each other at a same time, their respective latch arms retract and release from respective side latch recesses, allowing the fan module to be installed, or removed, from the chassis from the top position.

7. The rack-mounted server of claim 5 or 6, wherein the side latch recesses are defined by divider plates arranged on both sides of the fan module.

8. The rack-mounted server of claim 2 or 3, further comprising:
a removable top cover removably mounted to the chassis, and wherein when the removable top cover is mounted to the chassis and the fan module is installed in the chassis, the fan module is positioned beneath the removable top cover.

9. The rack-mounted server of any of claims 1 to 8, wherein the or each fan module has a fan module connector electrically coupled with an electrical connector arranged within the chassis.

10. The rack-mounted server of claim 1, wherein the fan tray comprises a plurality of latches, comprising:
a first left tray latch and a first right tray latch arranged at a left side and a right side of the fan tray, respectively; and
a second left tray latch and a second right tray latch arranged at the left side and the right side of the fan tray, respectively.

11. The rack-mounted server of claim 10, wherein the chassis has a first left tray pin and a first right tray pin, and wherein the first left tray latch and the first right tray latch are movable so as to lockingly engage, or release from, the first left tray pin and the first right tray pin, respectively, allowing the fan tray to be installed, or removed, from the chassis from the top position.

12. The rack-mounted server of claim 10 or 11, wherein the chassis has a second left tray pin and a second right tray pin, and wherein the second left tray latch and the second right tray latch are movable so as to lockingly engage, or release from, the second left tray pin and the second right tray pin, respectively, allowing the fan tray to be installed, or removed, from the chassis from the rear position.

13. The rack-mounted server of any of claims 10 to 12, wherein the first left tray latch and the first right tray latch are horizontally-oriented when the fan tray is installed in the chassis, and the second left tray latch and the second right tray latch are vertically-oriented when the fan tray is installed in the chassis.

14. A fan module for a rack-mounted server, the fan module comprising:
a housing having a top wall, a bottom wall, a left side wall, and a right side wall;
a fan disposed in the housing; and
a plurality of latches, including a top latch arranged at the top wall, a bottom latch arranged at the bottom wall, a left side latch arranged at the left side wall, and a right side latch arranged at the right side wall.

15. The fan module of claim 14 further comprising the features of any of claims 2 to 9.
